(19) Europäisches Patentamt
European Patent Office
Office européen des brevets

(11) EP 0 669 461 B1

# (12) FASCICULE DE BREVET EUROPEEN

(45) Date de publication et mention de la délivrance du brevet:
**20.08.1997 Bulletin 1997/34**

(51) Int Cl.6: **F03H 1/00**, H01J 37/08, H01J 27/02

(21) Numéro de dépôt: 95400277.0

(22) Date de dépôt: 10.02.1995

(54) **Système d'optique ionique à trois grilles**

Dreigitterionenoptische Vorrichtung

Three grid ion-optical device

(84) Etats contractants désignés:
DE GB IT

(30) Priorité: 24.02.1994 FR 9402108

(43) Date de publication de la demande:
30.08.1995 Bulletin 1995/35

(73) Titulaire: SOCIETE EUROPEENNE DE PROPULSION
92150 Suresnes (FR)

(72) Inventeur: Valentian, Dominique
F-78710 Rosny (FR)

(74) Mandataire: Thévenet, Jean-Bruno et al
Cabinet Beau de Loménie
158, rue de l'Université
75340 Paris Cédex 07 (FR)

(56) Documents cités:
EP-A- 0 339 554          EP-A- 0 406 441
EP-A- 0 526 420

• INSTRUMENTS AND EXPERIMENTAL TECHNIQUES, vol.24, no.5, NEW YORK US pages 1116 - 1117 V.I. DAVYDENKO ET AL. 'Study of a four-electrode multiple-slit system for ion-beam formation.'
• INSTRUMENTS AND EXPERIMENTAL TECHNIQUES, vol.28, no.4, NEW YORK US pages 907 - 909 B.I. ZHURAVLEV ET AL. 'Cold-cathode gas-discharge ion source.'

## Description

DOMAINE DE LA TECHNIQUE

La présente invention est relative au domaine des sources d'ions à décharge dans les gaz et, plus exactement, concerne un système d'optique ionique pour source d'ions à décharge dans un gaz et peut être utilisée dans des systèmes de formation de faisceaux ioniques intenses.

ART ANTERIEUR

On connaît des systèmes d'optique ionique pour sources d'ions à décharge dans un gaz comportant deux électrodes (ou plus) formées par des brides et des grilles en forme de disques plats avec des trous (Kaufman H.R. et Robinson, R.S, Minimum Hole Size in Ion Optics/J. Spacecraft and Rockets 1985, vol. 22, n° 3 pages 381-382).

Toutefois, ces systèmes d'optique ionique connus constitués par des grilles plates à orifices cylindriques coaxiaux se déforment pendant le fonctionnement sous l'effet des contraintes thermiques dues à l'échauffement de la structure, ce qui remet en cause la coaxialité des orifices et provoque une variation du jeu entre les grilles (modification des paramètres géométriques), qui peut amener une variation de la pervéance de chaque optique élémentaire puis, dans le cas de la diminution du jeu, un accroissement des forces électrostatiques pouvant amener un contact entre les grilles, donc un court circuit. En outre, en pratique le diamètre des optiques ioniques planes est limité à 100 mm.

Un remède connu appliqué pour les sources ioniques spatiales consiste à utiliser des grilles bombées (sphériques) beaucoup moins sensibles aux déformations thermiques et à l'influence déstabilisatrice des forces électrostatiques.

Cette technologie présente toutefois l'inconvénient d'être très complexe et particulièrement coûteuse.

Lorsqu'on utilise, dans un système d'optique ionique, des grilles traditionnelles avec des orifices ronds perforés dont les axes sont aux sommets d'un triangle équilatéral, la transparence $d_F$ de la grille (le rapport de la superficie cumulée des orifices de diamètre (d) à la superficie totale de la grille) se détermine par une formule connue :

$$d_F = 0,91 \frac{d^2}{(d+1)^2}$$

Une augmentation de la transparence permet d'utiliser plus efficacement la surface qui est la source d'ions ; la densité du courant à travers le système d'optique ionique diminuant avec l'augmentation de diamètre (d) d'orifice, il est souhaitable de réaliser des grilles en forme de disques à petits orifices et à transparence élevée. Pour cela, il faut que l'épaisseur du pont 1 entre les orifices soit au minimum de 0,5 mm, ce qui n'est pas technologiquement facile. Avec une telle configuration à orifices ronds, la transparence maximale que l'on peut obtenir pour la grille écran est de l'ordre de 0,67. L'utilisation d'orifices hexagonaux permet cependant de porter cette valeur maximale à 0,7.

On connaît également un système d'optique ionique pour source d'ions à décharge dans un gaz comportant une grille accélératrice et une grille écran formées de fils parallèles fixés sur des cadres par des ressorts à lame et constituant des fentes de sortie, ainsi que des groupes d'isolateurs sur lesquels les cadres sont installés (SU-A-472396).

Grâce à de telles électrodes constituées par des cadres à fils, on peut utiliser dans ce système des orifices de petits diamètres, ce qui assure une transparence élevée du système d'optique ionique, supérieure à 0,7.

On constate cependant encore, dans ce type de système d'optique ionique avec un jeu (fente) entre les fils de grilles de 0,3 à 0,5 mm, certains inconvénients. Tout d'abord, une médiocre stabilité de fonctionnement liée aux difficultés d'ajustage mutuel des fils des grilles écran ou accélératrice, cette imprécision d'ajustage provoquant la capture d'ions par la grille accélératrice et son usure rapide, ce qui entraîne une perturbation du fonctionnement de la source d'ions. Ensuite, l'érosion cathodique de la grille accélératrice a pour conséquence d'entraîner une projection des résidus de cette érosion sur le support à traiter, ce qui est de nature à limiter le domaine d'utilisation du dispositif. Enfin, une telle structure à deux grilles ne permet qu'une variation limitée des tensions d'alimentation des grilles.

DESCRIPTION DE L'INVENTION

L'objectif de l'invention est de réaliser un système d'optique ionique pour source d'ions à décharge dans un gaz dont la structure permette d'établir et de conserver constante la position spatiale des fils d'électrodes pendant le fonctionnement de la source d'ions, et d'améliorer la stabilité de fonctionnement du système avec conservation d'une transparence élevée. Un autre but de l'invention est d'augmenter la souplesse du dispositif quant à ses plages de fonctionnement comme à ses domaines d'utilisation, notamment en diminuant très sensiblement la pollution provoquée par l'érosion de la grille accélératrice.

Pour la solution de ce problème, il est proposé un système d'optique ionique pour source d'ions à décharge dans un gaz comportant une grille écran et une grille accélératrice constituées par des cadres respectifs et un ensemble de fils maintenus parallèles par un support et fixés sur ces cadres au moyen de ressorts, les cadres et les grilles étant assemblés par des isolateurs auxquels ils sont fixés, une grille décélératrice constituée d'un cadre et d'un ensemble de fils venant compléter ce système, le cadre de cette grille décélératrice étant emboîté dans le cadre de la grille accélératrice et séparé de celui-ci par des isolateurs.

Par la présence de cette grille décélératrice, la pollution provoquée par l'érosion de la grille accélératrice est limitée, ce qui permet d'augmenter les applications possibles du dispositif et d'en augmenter la fiabilité.

De préférence, le pas des fils de la grille écran est déterminé de telle sorte qu'il assure une convergence des faisceaux d'extrémités par rapport au faisceau central d'une valeur prédéterminée, avantageusement comprise entre 4 et 6°, et ainsi permette une adaptation locale de la pervéance.

Avantageusement, afin de limiter l'encombrement, les supports des fils sont constitués d'une plaque en forme de peigne.

Afin de renforcer l'effet de convergence, les supports, lorsqu'ils sont constitués par des rouleaux, sont profilés en forme de tonneau avec un diamètre variable augmentant de ses extrémités vers son centre. Cette forme spécifique des rouleaux bien adaptée à la grille écran peut aussi être adoptée pour les autres grilles.

Les fils de la grille décélératrice ont de préférence un diamètre identique ou supérieur à celui des fils de la grille écran mais inférieur à celui des fils de la grille accélératrice et au moins les fils de la grille accélératrice sont revêtus d'un dépôt du type PVD, CVD ou plasma, formé avantageusement de silicium, de bore ou de carbone, destiné à diminuer le taux d'érosion cathodique de la grille correspondante.

Pour assurer au système d'optique ionique selon l'invention une parfaite démontabilité, les fils des différentes grilles reliés et tendus par les ressorts sont pincés, par l'intermédiaire de douilles solidaires de ces ressorts, par un anneau en alliage à mémoire de forme.

Pour certaines applications où il est préférable que la focalisation du faisceau d'ions sortant du système d'optique ionique soit effectuée selon une section rectangulaire, le système selon l'invention comporte avantageusement une plaque carrée placée dans le trajet du faisceau d'ions traversant les grilles à fils et constituant une cible pour le matériau à déposer sur un substrat, cette plaque étant inclinée d'un angle déterminé par rapport à l'axe du faisceau d'ions, correspondant au taux maximal d'érosion cathodique du matériau à déposer. (de préférence cet angle est compris entre 30 et 45°).

## DESCRIPTION SUCCINCTE DES DESSINS

D'autres caractéristiques et avantages de la présente invention ressortiront mieux de la description détaillée suivante d'un mode préférentiel, faite à titre indicatif et non limitatif, en regard des dessins annexés, sur lesquels:

- la figure 1 représente de façon simplifiée en coupe transversale un système d'optique ionique à trois grilles selon l'invention,
- la figure 2 montre l'encastrement des grilles accélératrice et décélératrice du système de la figure 1,
- la figure 3 représente la structure de la grille écran du système de la figure 1,
- la figure 4 montre un détail des trois grilles selon la coupe III-III de la figure 1,
- la figure 5a représente un détail de réalisation d'un support des fils formé d'un rouleau muni d'un filetage,
- la figure 5b représente un autre dispositif de support des fils des grilles,
- la figure 6a représente une variante de réalisation d'un rouleau,
- la figure 6b est une courbe montrant le profil de densité ionique en sortie du système,
- la figure 7 est une variante de réalisation des rouleaux permettant d'assurer la convergence du faisceau d'ions,
- la figure 8 montre l'emploi d'une optique spécifique pour une meilleure focalisation du faisceau d'ions, et
- la figure 9 montre en détail le procédé de fixation des fils des grilles.

## MODE DE REALISATION PREFERENTIEL DE L'INVENTION

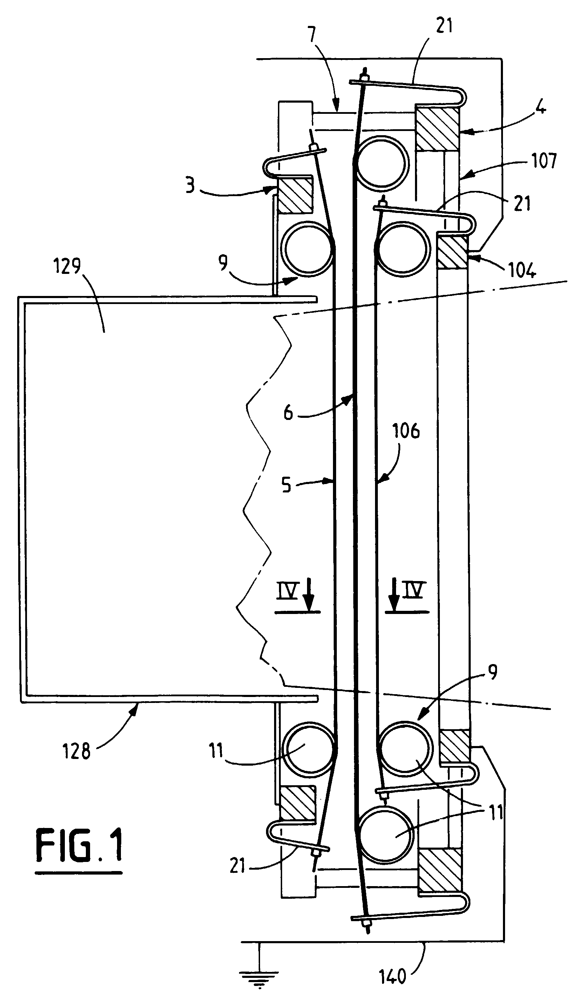

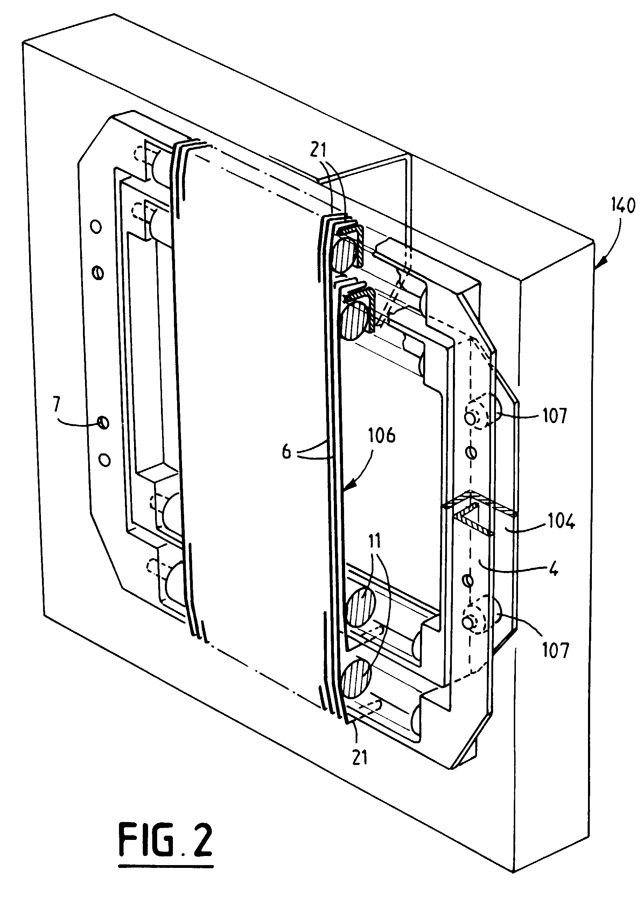

Selon la figure 1, le système d'optique ionique pour source d'ions à décharge dans un gaz selon l'invention comporte trois grilles (électrodes): une grille écran 1, une grille accélératrice 2 et une grille décélératrice 10 constituées respectivement par des cadres 3, 4, 104 auxquels sont associés respectivement des systèmes de fils parallèles 5, 6, 106. Des isolateurs 7, respectivement 107 sont disposés entre les cadres 3 et 4, respectivement 4 et 104. Un dispositif 9 pour le déplacement des fils de chacune des trois grilles permet de régler les différentes distances intergrilles à de faibles valeurs prédéterminées. Le cadre 104 de la grille décélératrice 106 est mis à la masse de la source ionique par l'intermédiaire d'un écran 140. Par une disposition judicieuse des cadres 4 et 104 qui sont emboîtés l'un dans l'autre (figure 2), il est possible d'assurer des très faibles distances intergrilles.

Les ions sont extraits à travers la grille écran 1 du plasma 129 produit par la chambre d'ionisation 128.

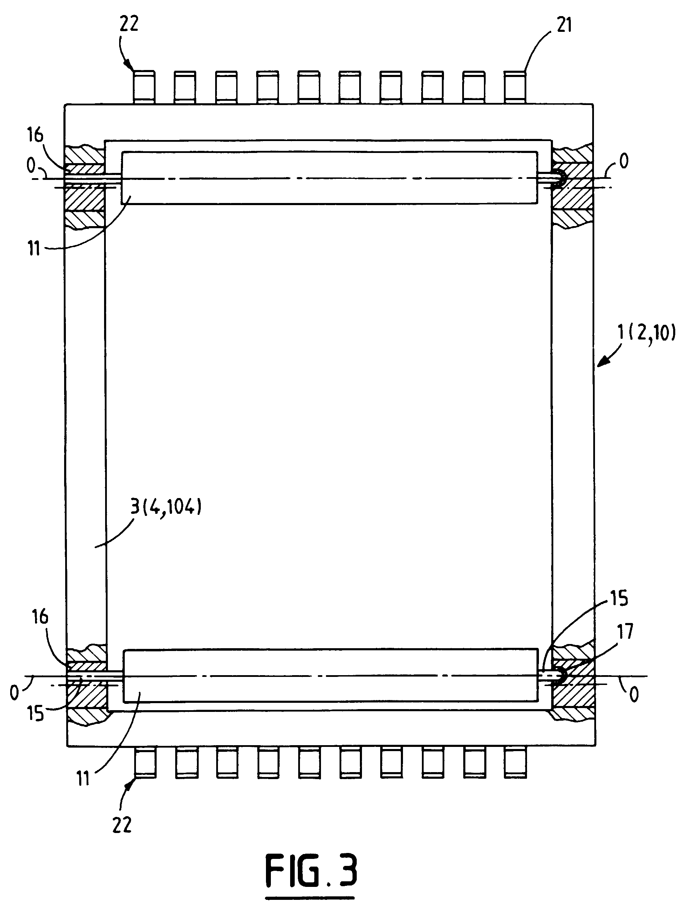

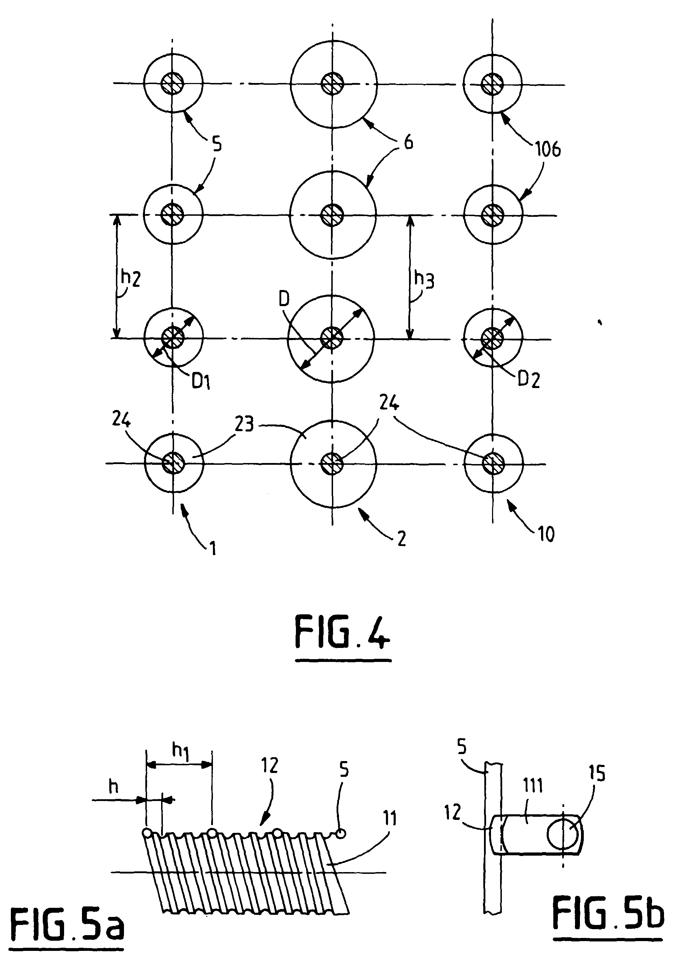

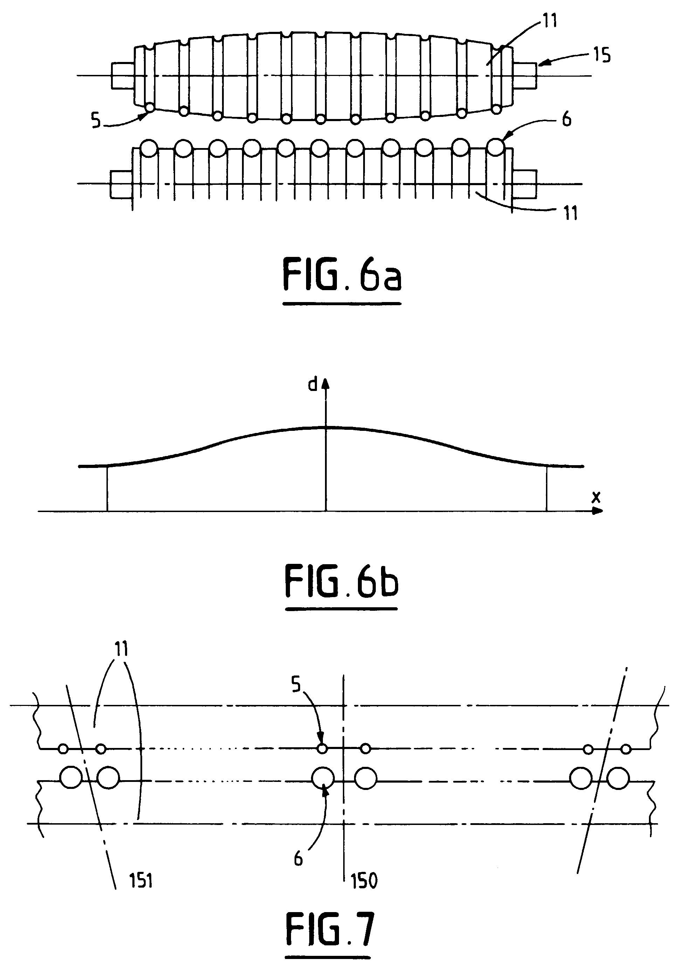

Comme le montrent les figures 2 et 3, le dispositif 9 de déplacement des fils, identique pour chaque grille, comporte des supports 11, avantageusement disposés par paire à chaque extrémité d'un cadre, placés transversalement aux fils 5, 6,106 de la grille concernée et des éléments de guidage 12 sont prévus à la surface externe de ces supports. Ces éléments de guidage peuvent être constitués par des gorges circulaires (voir figures 1 ou 6a) ou de préférence par un filetage (voir figure 5a) dont le pas h est égal au pas h1 des fils ou inférieur à ce pas dans un rapport entier, ce qui permet si nécessaire (voir notamment plus avant la description en regard de la figure 7) de disposer les fils de chaque grille avec un pas spécifié.

L'encastrement des cadres 4 et 104 est facilité par le profil en L de chacun d'eux, l'isolation par les isolateurs 107 pouvant alors être réalisé entre les parois parallèles respectives de ces deux profilés.

Les supports sont constitués très simplement par des rouleaux 11 ou, si l'on désire en limiter l'encombrement, par une plaque épaisse 111 en forme de peigne (figure 5b).

Les rouleaux 11 (ou les plaques 111) de chaque dispositif 9 sont installés dans les cadres 3, 4, 104 de chaque grille de façon qu'ils puissent tourner autour de leur axe O-O et changer leur position dans l'espace conjointement avec les fils. A cette fin, chacun de ces rouleaux est installé par ses bouts d'arbre 15 dans des manchons excentriques 16 disposés dans les cadres avec la possibilité de rotation autour de leur axe, l'un des bouts de chaque rouleau étant couplé au manchon excentrique 16 par un moyen de pivotement 17. Il peut être noté que cet arrangement permet en outre de régler séparément la distance moyenne intergrille et le défaut de parallélisme entre grilles.

En fonction du domaine d'utilisation des systèmes d'optique ionique proposés, les fils 5 de la grille écran 1 sont disposées suivant un pas $h_2$ égal au pas $h_3$ des fils 6 de la grille accélératrice 2 (figure 4) ou suivant un pas plus petit que le pas des fils 6 de la grille accélératrice 2 dans un rapport entier, ce qui a pour résultat qu'une même fente de la grille accélératrice 2 est perméable aux faisceaux d'ions formés par plusieurs fentes de la grille écran 1. Les fils 6 de la grille accélératrice 2 ont un diamètre D plus grand que le diamètre $D_1$ des fils 5 de la grille écran 1, de façon que la transparence de celle-ci soit supérieure à la transparence de celle-là, ce qui se traduit par une meilleure efficacité du système en gaz, la transparence du système d'optique ionique en ions étant déterminée dans ce cas-là par la transparence de la grille écran 1 et la transparence en atomes par la transparence de la grille accélératrice 2. De même, le diamètre D2 des fils de la grille décélératrice 10 est de préférence identique voire supérieur à celui de la grille écran D1, sans toutefois pouvoir excéder celui de la grille accélératrice D.

Dans le système d'optique ionique, lorsque le jeu intergrille entre la grille écran 5 et la grille accélératrice 6 est petit et que les courants sont proches des limites, il est difficile de maintenir l'angle de divergence du faisceau d'ions dans des limites données. Aussi, pour adapter la perveance locale à la densité locale dans la chambre d'ionisation, il est possible de modifier le profil des rouleaux supportant les fils de la grille écran 5 de telle sorte que ceux-ci présentent une forme de tonneau avec un diamètre variable augmentant de ses extrémités vers son centre (voir figure 6a). La figure 6b montre le profil de la densité ionique en aval de l'ensemble optique obtenue avec une telle structure de rouleau. Cette forme de tonneau peut aussi être envisagée pour les grilles accélératrice et décélératrice.

La convergence du faisceau d'ions peut également être améliorée en modifiant très légèrement le pas des fils des grilles tel que le montre (avec une exagération volontaire) la figure 7. Il est ainsi possible de faire converger les faisceaux élémentaires d'extrémité 151 de quelques degrés, avantageusement de 4 à 6°, vers le faisceau central 150. Bien évidemment, cette disposition peut être combinée avec la structure en tonneau précédente pour, de ce fait, adapter la perveance locale et renforcer l'effet de convergence.

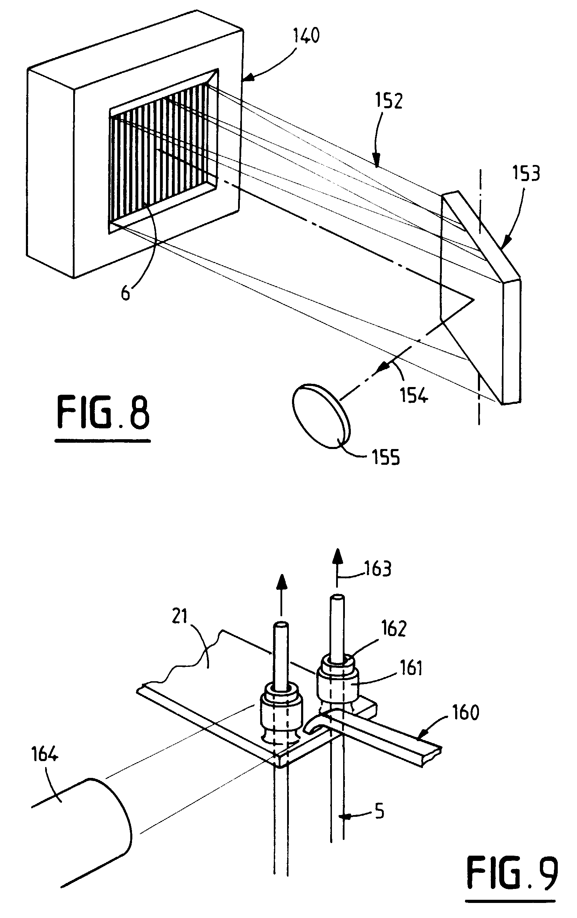

Les fils 5, 6, 106 des grilles 1, 2, 10 sont fixés (le moyen de fixation sera explicité en regard de la figure 9) à des ressorts à lame 21 liés solidairement aux cadres 3, 4, 104, ces ressorts étant alignés parallèlement aux rouleaux 11 et placés sur un même rang 22 le long de chacun des cotés opposés des cadres. Pour réduire la charge des ressorts 21, les fils des grilles sont avantageusement réalisés en deux parties coaxiales 23 et 24 dont la partie extérieure forme un tube installé avec ajustement doux sur la partie intérieure. Lorsque seuls les fils 6 de la grille accélératrice sont réalisés en deux parties coaxiales, la partie intérieure 24 de tels fils a de préférence un diamètre égal à celui des fils 5, 106 des grilles écran et décélératrice. Ce mode de réalisation de la grille accélératrice offre ainsi la possibilité de remplacer rapidement la partie usée et réduite à cause de l'érosion de son matériau pendant le fonctionnement de la source, ce qui permet d'augmenter la durée de vie de cette grille. Une autre solution pour réduire cette érosion cathodique, dite aussi "sputtering", de la grille accélératrice consiste à éliminer les interactions gaz neutre (ou réactif) et grille en utilisant un revêtement chimiquement compatible ou, par exemple dans le cas d'une application à la gravure de microcircuits, un revêtement compatible avec le semiconducteur à graver, éliminant ainsi les conséquences d'une pollution due à cette érosion.

La réalisation d'un dépôt sur un fil par dépôt chimique en phase vapeur (CVD) ou dépôt physique en phase vapeur (PVD), ou une autre méthode équivalente comme un dépôt plasma est très facile alors qu'elle serait plus complexe sur une grille à trous de l'art antérieur. Par exemple, un revêtement de silicium sur du tungstène donnera en cas d'érosion un dépôt de silicium sur le microcircuit à graver ce qui n'est pas gênant alors qu'une contamination par le tungstène est de nature à polluer ce microcircuit. Le bore ou le carbone sont également des constituants particulièrement bien adaptés à un tel dépôt.

La mise en service du système d'optique ionique proposé s'effectue d'une façon traditionnelle : un potentiel correspondant à l'énergie des ions dans le faisceau, par exemple de +700 V à 3 kV, est appliqué à la grille écran 1 (figure 1) et un potentiel de -0,2 kV à -2 kV est appliqué à la grille accélératrice 2, ce qui est nécessaire pour créer une différence de potentiel d'extraction. La grille décélératrice est quant à elle reliée à la masse. Le cadre de sortie 140 normalement réalisé sous forme d'une grille annulaire ou à section carrée est également mis à la masse. Dans la chambre de décharge de la source, Le plasma est automatiquement stabilisé au voisinage de la grille écran dans la région où la neutralité du plasma n'existe plus. En utilisant dans les grilles des fils 5 et 6 réalisés conformément aux figures 2 et 3 et des rouleaux 11 conçus selon la figure 6a, on atteint la transparence spécifiée pour les grilles accélératrice 2 et écran 1 et la divergence du jet d'ions ne dépasse pas les valeurs spécifiées. La présence de la grille décélératrice 10 permet de capter les résidus de l'érosion provenant de la grille accélératrice 6 et ainsi d'éviter toute pollution du produit à traiter. De même, en remplaçant chaque fil de la grille écran par trois fils ou plus disposés selon un motif géométrique déterminé, il est possible de connaître d'une manière plus précise à la fois les équipotentielles dans la zone d'accélération et la limite du plasma dans la chambre d'ionisation.

S'il est nécessaire de réaliser une forme spécifiée de la surface de chaque grille et de mettre en coïncidence les fils, on procède d'abord au réglage de mise en place de la position des fils avec le dispositif 9.

La forme spécifiée de chaque grille peut être réalisée par rotation de manchons excentriques 16 (figure 3) pendant laquelle les fils se déplacent dans la direction perpendiculaire au plan du cadre. La coïncidence des fentes dans les différentes grilles est obtenue par rotation des rouleaux 11 autour de leur axes.

L'utilisation, par exemple, d'un cathétomètre garantit la précision géométrique des paramètres du système d'optique ionique à ± 0,01 mm près.

La possibilité de réaliser les réglages indiqués permet d'augmenter la stabilité du fonctionnement de la source d'ions, car on garantit une précision élevée d'ajustement des fils l'un par rapport à l'autre dans chaque grille et la valeur souhaitée des jeux intergrille. La position mutuelle des fils est maintenue pendant le fonctionnement du système, ce qui assure un fonctionnement stable et durable de la source d'ions.

Pour certaines applications spécifiques, comme le revêtement par érosion cathodique, il est intéressant de focaliser le faisceau, initialement de section carrée, selon une section rectangulaire. La figure 8 montre un moyen simple d'aboutir à une telle focalisation. Pour cela, le faisceau d'ions 152 sortant du cadre de sortie 140 de l'optique ionique est dirigé vers une plaque cible carrée 153 orientée selon un angle de 30 à 45° (pour assurer un coefficient de "sputtering" maximum) par rapport à l'axe du faisceau, le matériau à traiter 155, c'est à dire par exemple le substrat à revêtir, recevant les atomes 154 arrachés à cette plaque sous l'effet de cette érosion cathodique.

La figure 9 montre le procédé de fixation des différents fils 5, 6, 106 sur les ressorts à lames 21 de chacun des cadres 3, 4, 104. Ces fils, par exemple 5, sont fixés aux ressorts 21 au moyen de bagues en alliage à mémoire de forme 161 montées chacune sur une douille interne 162 solidaire du ressort. La fixation des fils résultant du pincement de ces douilles sur le fil, qui s'effectue sous l'action d'un gaz froid (délivré par le tube 164) destiné à provoquer le changement d'état des bagues, ne demande que de simples outillages de mise en contrainte du ressort 160 et de mise en traction du fil 163. Avec une telle fixation, il est ainsi aisé de procéder au démontage des fils comme des rouleaux.

De par ses excellentes performances, l'optique ionique à trois grilles selon l'invention est applicable aux sources d'ions étendues utilisant l'ionisation d'un gaz par l'un des processus suivants :

- ionisation par bombardement électronique (sources d'ions dites de Kaufman),
- ionisation par champ radiofréquence (sources d'ions type RIT (Radiofrequency Ionisation Thrusters), ou encore
- ionisation par résonance cyclotronique électronique (E.C.R.).

Ce système d'optique est notamment applicable :

- à la propulsion spatiale en remplacement des grilles bombées traditionnelles, ou
- aux applications industrielles : gravures de microcircuits, usinage ionique, dépôts sous vide par sputtering.

Pour ces applications industrielles, l'optique ionique à fils présente deux avantages essentiels :

- la divergence du faisceau d'ions dans un plan parallèle aux fils est très faible, ce qui est intéressant pour les applications de gravure.
- La pervéance d'une optique à fils étant très élevée, cela permet d'extraire une densité d'ions supérieure à tension nette d'accélération égale, ce qui est intéressant pour les applications industrielles à énergie moyenne (500eV).

**Revendications**

1. Système d'optique ionique pour source d'ions à décharge dans les gaz comportant, disposées successivement dans le sens de déplacement des ions :

   . une grille écran (1) formée d'un premier ensemble de fils (5) tendus sur un cadre (3) par des ressorts (21),
   . une grille accélératrice (2) formée d'un deuxième ensemble de fils (6) tendus sur un cadre (4) par des ressorts (21); et
   . une grille décélératrice (10) formée d'un troisième ensemble de fils (106), tendus sur un cadre (104) par des ressorts (21), ce cadre étant emboîté dans le cadre (4) de la grille accélératrice (2) ; les fils (5, 6, 106) de chacune de ces grilles étant maintenus parallèles par des éléments de guidage (12) prévus au niveau de moyens support (11) solidaires du cadre (3, 4, 104) et placés transversalement à ces fils, des isolateurs (7, 107) fixés entre les cadres (3, 4, 104) assurant en outre une séparation électrique entre les grilles (1, 2, 10).

2. Système d'optique ionique selon la revendication 1, caractérisé en ce que lesdits moyens support sont articulés dans chaque cadre (3, 4, 104) par un dispositif de déplacement à excentriques (9) permettant un déplacement des fils (5, 6, 106) dans une direction perpendiculaire au plan du cadre.

3. Système d'optique ionique selon la revendication 1, caractérisé en ce que le pas des fils (5) de la grille écran (1) est déterminé par rapport au pas de la grille accélératrice (6) de telle sorte qu'il assure une convergence des faisceaux d'extrémités (151) par rapport au faisceau central (150) d'un angle prédéterminé.

4. Système d'optique ionique selon la revendication 3, caractérisé en ce que l'angle de convergence des faisceaux d'extrémité (151) est compris entre 4 et 6°.

5. Système d'optique ionique selon la revendication 1, caractérisé en ce que lesdits supports (11) des fils (5,6,106) sont constitués d'une plaque (111) en forme de peigne.

6. Système d'optique ionique selon la revendication 1, caractérisé en ce que lesdits supports (11) sont constitués par des rouleaux dont au moins les rouleaux installés dans la grille écran (5) sont profilés en forme de tonneau avec un diamètre variable augmentant de ses extrémités vers son centre.

7. Système d'optique ionique selon la revendication 1, caractérisé en ce que les fils (106) de la grille décélératrice (10) ont un diamètre identique ou supérieur à celui des fils (5) de la grille écran (1) mais inférieur à celui des fils (6) de la grille accélératrice (2).

8. Système d'optique ionique selon la revendication 7, caractérisé en ce qu'au moins les fils (6) de la grille accélératrice (2) comportent un revêtement destiné à diminuer le taux d'érosion cathodique de ladite grille et réalisé selon l'une des méthodes du type dépôt chimique en phase vapeur (CVD), dépôt physique en phase vapeur (PVD) ou dépôt plasma.

9. Système d'optique ionique selon la revendication 8, caractérisé en ce que ledit revêtement est formé d'un constituant tel que le silicium, le bore, ou le carbone.

10. Système d'optique ionique selon la revendication 1, caractérisé en ce que les fils (5,6,106) des différentes grilles (1,2,10) sont reliés et tendus par les ressorts (21) par l'intermédiaire de douilles (162) solidaires de ces ressorts et pincées sur les fils par un anneau en alliage à mémoire de forme (161).

11. Système d'optique ionique selon la revendication 1, caractérisé en ce qu'il comporte en outre une plaque carrée (153) placée dans le trajet du faisceau d'ions (152) traversant les grilles à fils et constituant une cible pour le matériau à déposer sur un substrat (155), cette plaque étant inclinée d'un angle déterminé par rapport à l'axe du faisceau d'ions.

12. Système d'optique ionique selon la revendication 11, caractérisé en ce que ledit angle déterminé d'inclinaison est compris entre 30 et 45°.

**Patentansprüche**

1. Ionenoptisches System für eine Ionenquelle zur Entladung im Gas, bei dem aufeinanderfolgend in der Verschiebungsrichtung der Ionen

ein aus einer ersten Menge von mittels von Federn (21) auf einen Rahmen (3) gespannten Drähten (5) gebildetes Abschirmungsgitter (1), ein aus einer zweiten Menge von mittels von Federn (21) auf einen Rahmen (4) gespannten Drähten (6) gebildetes Beschleunigungsgitter (2) und ein aus einer dritten Menge von mittels von Federn (21) auf einen Rahmen (104) gespannten Drähten (106) gebildetes Verzögerungsgitter, wobei der Rahmen in den Rahmen (4) des Beschleunigungsgitters (2) eingefügt ist, die Drähte (5, 6, 106) jedes der Gitter mittels von Führungselementen (12) parallel gehalten werden, die auf einer Ebene von fest mit dem Rahmen (3, 4, 104) verbundenen Trägereinrichtungen (11) vorgesehen und transversal zu den Drähten angeordnet sind, wobei Isolatoren (7, 107), die unter anderem eine elektrische Trennung zwischen den Gittern (1, 2, 10) sicherstellen, zwischen den Rahmen (3, 4, 104) befestigt sind angeordnet sind.

2. Ionenoptisches System nach Anspruch 1, dadurch gekennzeichnet, daß die Trägereinrichtungen in jedem Rahmen mittels einer exzentrischen Verschiebungsvorrichtung (9) ausgebildet sind, die eine Verschiebung der Drähte (5, 6, 106) in einer Richtung senkrecht zu einer Rahmenebene erlaubt.

3.  Ionenoptisches System nach Anspruch 1, dadurch gekennzeichnet, daß
    der Abstand der Drähte (5) des Abschirmungsgitters (1) mittels der Beziehung zum Abstand des Beschleunigungsgitters (6) derart bestimmt ist, daß eine Konvergenz der Strahlen von den Rändern (151) mittels Beziehung zum zentralen Strahl (150) mit einem vorbestimmten Winkel sichergestellt ist.

4.  Ionenoptisches System nach Anspruch 3, dadurch gekennzeichnet, daß
    der Konvergenzwinkel der Strahlen vom Rand (151) zwischen 4 und 6° beträgt.

5.  Ionenoptisches System nach Anspruch 1, dadurch gekennzeichnet, daß
    die Träger (11) der Drähte (5, 6, 106) aus einer Platte (111) in Form eines Kamms gebildet sind.

6.  Ionenoptisches System nach Anspruch 1, dadurch gekennzeichnet, daß
    die Träger (11) mittels von Zylindern gebildet sind, von denen zumindest die im Abschirmungsgitter (5) installierten Zylinder in Form einer Tonne mit einem veränderlichen Durchmesser, der sich von seinen Enden zu seiner Mitte erhöht, profiliert sind.

7.  Ionenoptisches System nach Anspruch 1, dadurch gekennzeichnet, daß
    die Drähte (106) des Verzögerungsgitter (10) einen identischen oder größeren Durchmesser als der der Drähte (5) des Abschirmungsgitters (1), aber kleiner als der der Drähte (6) des Beschleunigungsgitters (2) besitzen.

8.  Ionenoptisches System nach Anspruch 7, dadurch gekennzeichnet, daß
    zumindest die Drähte (6) des Beschleunigungsgitters (2) eine Beschichtung aufweisen, die zur Verringerung der Kathodenerosionsrate des Gitters bestimmt ist und gemäß der Beschichtungsverfahren vom Typ chemischer Beschichtung aus der Gasphase (CVD), physikalischer Beschichtung aus der Gasphase (PVD) oder Plasma-Beschichtung verwirklicht ist.

9.  Ionenoptisches System nach Anspruch 8, dadurch gekennzeichnet, daß
    die Beschichtung aus einem Bestandteil wie Silizium, Bor oder Kohlenstoff gebildet ist.

10. Ionenoptisches System nach Anspruch 1, dadurch gekennzeichnet, daß
    die Drähte (5, 6, 106) der verschiedenen Gitter (1, 2, 10) verbunden und mittels der Federn (21) durch mit diesen Federn fest verbundene Zwischenbuchse (162) gespannt und über die Drähte mittels eines Rings aus einer Legierung mit Formspeicherung (161) geklemmt sind.

11. Ionenoptisches System nach Anspruch 1, gekennzeichnet durch eine andere quadratische Platte (153), die im Ionenstrahlgang (152) angeordnet ist, der die Gitter als Drähten quert und ein Ziel für das auf ein Substrat (155) aufzubringende Material bildet, wobei die Platte in einem durch die Beziehung zur Achse des Ionenstrahls bestimmten Winkel geneigt ist.

12. Ionenoptisches System nach Anspruch 11, dadurch gekennzeichnet, daß
    der bestimmte Neigungswinkel zwischen 30 und 45° beträgt.

## Claims

1.  An ion-optical system for a gas-discharge ion source, the system comprising successively arranged in the displacement direction of the ions:

    .   a screen grid (1) constituted by a first set of wires (5) tensioned on a frame (3) by springs (21);
    .   an accelerator grid (2) constituted by a second set of wires (6) tensioned on a frame (4) by springs (21); and
    .   a decelerator grid (10) constituted by a third set of wires (106), tensioned on a frame (104) by springs (21), said frame being engaged in the frame (4) of the accelerator grid (2); the wires (5, 6, 106) of each one of these grids being held parallel by guide elements (12) that are provided at the level of support means (11) fixed to the frame (3, 4, 104) and placed transversely to these wires, insulators (7, 107) fixed between the frames (3, 4, 104) thus further ensuring an electrical separation between the grids (1, 2, 10).

2.  The ion-optical system according to claim 1, characterized in that said support means are articulated in each frame (3, 4, 104) by an eccentric displacement device (9) which makes it possible to displace wires (5, 6, 106) in a direction that is perpendicular to the plane of the frame.

3.  The ion-optical system according to claim 1, characterized in that the pitch of the wires (5) of the screen grid (1) is determined with respect to the pitch of the accelerator grid (6) in such a manner as to ensure that the outermost beams (151) converge towards the central beam (150) by a predetermined angle.

4. The ion-optical system according to claim 3, characterized in that the angle of convergence for the outermost beams (151) lies in the range 4° to 6°.

5. The ion-optical system according to claim 1, characterized in that said supports (11) for the wires (5, 6, 106) are constituted by respective plates (111) in the form of combs.

6. The ion-optical system according to claim 1, characterized in that said supports (11) are constituted by rollers with at least the rollers installed in the screen grid (5) being shaped so as to be barrel-shaped, having a larger diameter in its center than at its end.

7. The ion-optical system according to claim 1, characterized in that the diameter of the wires (106) of the decelerator grid (10) is identical to or greater than the diameter of the wires (5) of the screen grid (1), but less than the diameter of the wires (6) of the accelerator grid (2).

8. The ion-optical system according to claim 7, characterized in that at least the wires (6) of the accelerator grid (2) comprise a coating that is designed to reduce the cathode erosion rate of said grid and that is made according to one of the methods of the chemical vapor deposition type (CVD), physical vapor deposition type (PVD), or plasma deposition type.

9. The ion-optical system according to claim 8, characterized in that said coating is constituted by silicon, boron, or carbon.

10. The ion-optical system according to claim 1, characterized in that the wires (5, 6, 106) of the various grids (1, 2, 10) are connected to and tensioned by springs (21) via sockets (162) secured to said springs and clamped on the wires by rings made of shape memory alloy (161).

11. The ion-optical system according to claim 1, characterized in that it further comprises a square plate (153) placed on the path of the ion beam (152) that passes through the grids of wires and constituting a target of the material to be deposited on a substrate (155), said plate being inclined at a given angle relative to the axis of the beam of ions.

12. The ion-optical system according to claim 11, characterized in that said given angle of inclination lies in the range 30° to 45°.

FIG.1

**FIG.2**

FIG.3

FIG.4

FIG.5a

FIG.5b

## FIG. 6a

## FIG. 6b

## FIG. 7

13

FIG. 8

FIG. 9